# EUROPEAN PATENT APPLICATION

(11) **EP 4 174 918 A2**
(43) Date of publication of application: **03.05.2023**
(21) Application number: 22199868.5
(22) Date of filing: 05.10.2022
(51) Int. Cl.: H01L 21/60, H01L 23/13, H01L 25/065, H01L 21/98

(54) **STACKING A SEMICONDUCTOR DIE AND CHIP-SCALE-PACKAGE UNIT**

(30) Priority: 29.10.2021 US 202117452905
(71) Applicant: NXP B.V., 5656 AG Eindhoven (NL)
(72) Inventor: Singh, Akhilesh Kumar, 5656AG Eindhoven (NL); Foong, Chee Seng, 5656AG Eindhoven (NL); Swartjes, Franciscus Henrikus Martinus, 5656AG Eindhoven (NL); Mawer, Andrew Jefferson, 5656AG Eindhoven (NL)
(74) Representative: Hardingham, Christopher Mark

(57) **Abstract**

There is disclosed a semiconductor package assembly comprising: a substrate (110) having a top substrate surface (112) and a substrate bottom surface (114); a first semiconductor die (120), partially over the substrate and having a die bottom surface having first and second pluralities of I/O pads thereon; a first plurality of localised electrical connection components (LECCs) (150), affixed between the die bottom surface and the substrate top surface and providing electrical connections between the substrate and the first plurality of I/O pads; a second plurality of LECCs (118), affixed to the substrate bottom surface, and for providing electrical connection between the substrate and a circuit board (170); wherein the second plurality of I/O pads are arranged for providing electrical connections to a chip-scale-package unit (130) to be affixed to the first semiconductor die by a third plurality of LECCs (160), and to be positioned in a same horizonal plane as the substrate. Corresponding methods are also disclosed.

## Description

### Field

The present disclosure refers to semiconductor package assemblies and subassemblies, and to methods for assembling semiconductor packages.

### Background

The vast majority of integrated circuits devices are currently provided as a monolithic chip - that is to say the circuitry is provided within a single device. However, as circuit complexity increases the increased functionality and complexity results in increased die and package size, and result manufacturing yields tends to drop, with increasing die size and complexity. Furthermore, providing inputs and outputs the chip, also referred to as "I/O routing" becomes increasingly complex and challenging as chip functionality and size increases, as does managing the soil more characteristics of the dial package.

It is known to produce multichip packages (MCM), but most MCM concepts significantly increase the complexity of manufacturing.

### Summary

According to a first aspect of the present disclosure, there is provided a semiconductor package assembly comprising: a substrate having a substrate top surface and a substrate bottom surface; a first semiconductor die, partially over the substrate and having a die bottom surface having first and second pluralities of I/O pads thereon; a first plurality of localised electrical connection components, between and affixed to each of the die bottom surface and the substrate top surface and providing electrical connections between the substrate and the first plurality of I/O pads; a second plurality of localised electrical connection components, affixed to the substrate bottom surface, and for providing electrical connection between the substrate and a circuit board; wherein the second plurality of I/O pads are arranged for providing electrical connections to a chip-scale-package unit to be affixed to the first semiconductor die by a third plurality of localised electrical connection components, and to be positioned in a same horizonal plane as the substrate. Such embodiments may be suitable for assembly with a suitable chip-scale-package unit either prior to or concurrent with mounting or assembly onto a circuit board.

In one or more embodiments, the semiconductor package assembly further comprises the third plurality of localised electrical connection components affixed to the die bottom surface and for providing electrical connection between the first semiconductor die and the chip-scale-package unit. When used with a suitable chip-scale-package unit, the chip-scale-package unit may thus not require balls, bumps or pillars on its top surface.

In one or more embodiments, the semiconductor package assembly further comprises the chip-scale-package unit, having a chip-scale-package unit top surface to which the third plurality of localised electrical connection components are affixed and a chip-scale-package unit bottom surface. In such embodiments, the semiconductor package assembly may be available for assembly or mounting onto a circuit board as a single component.

In one or more embodiments the chip-scale-package unit is proximate to the substrate on at least two sides. In one or more embodiments the chip-scale-package unit is surrounded by the substrate on all sides. The chip-scale-package unit may be laterally spaced apart from the substrate by at least a distance. The distance may be chosen to allow for at least one of manufacturing tolerances and placement tolerances, and for differences in thermal expansion. In some embodiments it is or may be desirable to keep the distance to a minimum in order to minimise the space taken on the circuit board, or to maximise the space available on the substrate for bumps, balls or pillars.

In one or more embodiments, the semiconductor package assembly further comprises a fourth plurality of localised electrical connection components, affixed to the substrate bottom surface and for providing electrical connection between the substrate and a circuit board.

In one or more embodiments, the semiconductor package assembly further comprises a fifth plurality of localised electrical connection components, affixed to the chip-scale-package unit bottom surface and for providing electrical connection between the chip-scale-package unit and a circuit board. The fourth and fifth pluralities may each be the same size or height - in particular in embodiments in which the bottom surface of substrate is coplanar with the bottom surface of the chip-scale-package; in other embodiments the fourth and fifth pluralities may be of different sizes or heights.

In one or more embodiments the substate extends laterally beyond the semiconductor die, for instance due to physical restriction of line space imposed by circuit design, which may increase from die level to substrate, the substrate may have a different shape and size than the die.. In one or more other embodiments the semiconductor die extends laterally beyond the substrate. This may enable or assist in efficient usage of area or "real-estate", for instance in applications having restricted or limited space on a circuit board to which the chip-scale-package is to be mounted; for instance it may be possible to position surface mount passive devices, or other components, on the circuit board underneath the overhanging semiconductor die There will be appreciated in some embodiments these two features may be mixed such that in one dimensional direction the semiconductor die extends laterally beyond substrate and in a perpendicular direction the substrate extends laterally beyond the semiconductor die

In one or more embodiments the substate extends laterally beyond the semiconductor die.

In one or more embodiments the chip-scale-package unit consists of a single chip-scale-package die. In one or more other embodiments the chip-scale-package unit comprises a stacked pair of chip-scale-package die. In yet other embodiments, the semiconductor package assembly comprises one or more additional chip-scale-package units, each or any of which may comprise a stacked pair of chip-scale-package die or a single chip-scale-package die. Furthermore, in yet other embodiments, the semiconductor package assembly does not comprise such additional chip-scale-package units, but is configured so as to be assembled in with it or them.

In one or more embodiments, the semiconductor package assembly further comprises moulding compound at least partially surrounding at least one of the pair of chip-scale-package die.

According to another aspect of the present disclosure, there is provided a method of assembling a semiconductor package which includes a chip-scale-package unit comprising: providing a first semiconductor die; providing a first plurality of localised electrical connection components on the first semiconductor die; affixing a substrate to the first plurality of localised electrical connection components; and affixing a chip-scale-package unit in a same plane as the substrate, to the first semiconductor die.

These and other aspects of the invention will be apparent from, and elucidated with reference to, the embodiments described hereinafter.

### Brief description of Drawings

Embodiments will be described, by way of example only, with reference to the drawings, in which
FIG. 1 illustrates a semiconductor package assembly according to one or more embodiments, in the top part of the figure in cross-section, and in the lower part of the figure in plan view from below or underneath;
FIG. 2 illustrates a first configuration of a semiconductor package assembly according to one or more embodiments;
FIG. 3 illustrates a second configuration of a semiconductor package assembly according to one or more embodiments;
FIG. 4 illustrates 1/3 configuration of a semiconductor package assembly according to one or more embodiments;
FIG. 5A - FIG. 5E illustrate several layouts or arrangements of semiconductor package assemblies according to different embodiments, in each case in plan view from underneath;
FIG. 6A - FIG. 6E illustrate various chip-scale-package assembly units according to, or designed for use in conjunction with, one or more embodiments;
FIG. 7A illustrates a cross-sectional view of each step of a package assembly process according to an embodiment; and
FIG. 7B illustrates a flowchart of the package assembly process of FIG. 7A.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments

### Detailed description of embodiments

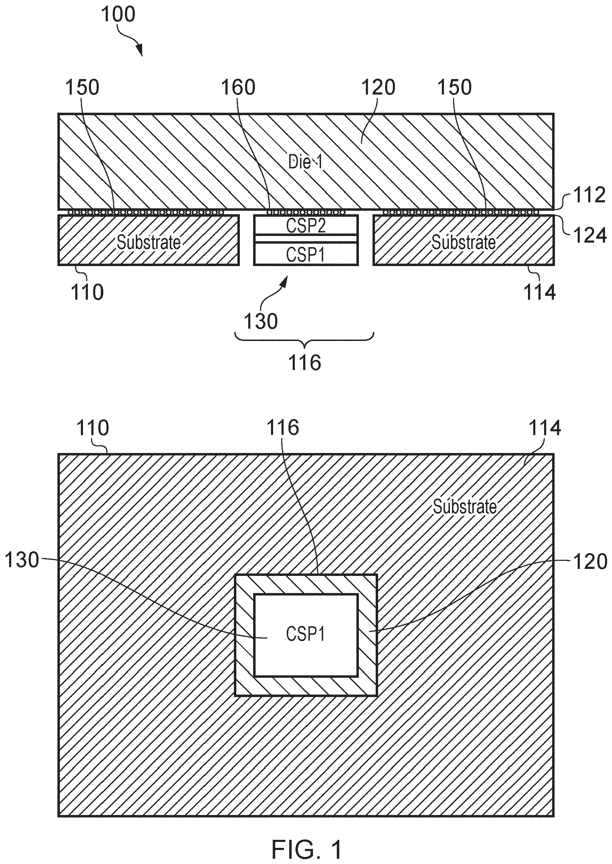

FIG. 1 shows a semiconductor package assembly 100 according to one or more embodiments, shown in section in the top half of the FIG. 1 and in plan view (from underneath) in the bottom half of FIG. 1. The semiconductor package assembly 100 comprises a substrate 110 having a top substrate surface 112 and a substrate bottom surface 114. The semiconductor package assembly 100 further comprises a first semiconductor die 120. The semiconductor package assembly 100 further comprises a chip-scale-package unit 130,

The substrate may typically be of a polymer material, and typically may be single or multiple layers of composite organic material. The substrate includes metallic or other conductive routings therein or thereon, which are typically embedded. The thermal coefficient of expansion of the substrate may be chosen to be similar to that of the semiconductor die. In one or other more embodiments, the substrate may be a semiconductor material with conductive routings. As shown, the first semiconductor die is partially over the substrate. That is to say, some part of the first semiconductor die is over the substrate, and there is at least some part of the first semiconductor die which is not over the substrate. In the embodiment shown, this latter part corresponds to the part of the die which is over a cut-out region, or aperture, 116 in the substrate. In one or more other embodiments, as will be described in more detail hereinbelow, the part of the first semiconductor die which is not over the substrate may extend laterally beyond the substrate, or may be over a "missing corner" or "missing notch" located generally near a corner or along an edge of the substrate.

The first semiconductor die has a die bottom surface 124, having first and second pluralities of I/O pads thereon (not shown in FIG. 1). A first plurality of localised electrical connection components 150 are affixed between the die bottom surface and the substrate top surface, and provide electrical connections between the substrate and the first plurality of I/O pads. Again, as will be described in more detail hereinbelow, the localised electrical connection components may be in the form of bumps, balls, or metal pillars. (Metal pillars may also be referred to as Cu-studs since copper is currently a commonly used material to fabricate the metal pillars. The skilled person will appreciate however that alternatives or additions to copper might be used in the case of metal pillars.) The localised electrical connection components may, in the alternative, be referred to as electrical interconnects.

A second plurality of localised electrical connection components (not shown in FIG. 1), is affixed to the substrate bottom surface, for providing electrical connection between the substrate and a circuit board. In FIG. 1, the circuit board is not part of the assembly.

A second plurality of I/O pads (not shown) is arranged for providing electrical connection to the chip-scale-package unit 116. In the embodiment shown in FIG. 1, the chip-scale-package (CSP) unit 116 is affixed to the first semiconductor die by a third plurality of localised electrical connection components 160. In other embodiments, and in particular for semiconductor package assemblies designed for integration alongside separate CSP unit, the CSP unit may not be included in the assembly. Furthermore, in such assemblies, the localised electrical connection components 160 may be affixed to the die 120, or to the CSP unit 116. In the latter case, the localised electrical connection components 160 may also not be included in the assembly.

As shown, the CSP unit is generally in a same horizonal plane as the substrate. The top surface of the CSP units, to which the first plurality of localised electrical connection components 160 either are attached or are to be attached, may in the same plane as the top surface of the substrate 112. In such embodiments, the height (in a vertical direction) of the localised electrical connection components 160 matches the height (in a vertical direction) of the electrical components 150, to within normal manufacturing tolerances.

In other embodiments, the height of the first plurality of localised electrical connection components 160 may be greater or smaller than that of the first plurality of electrical convection components 150. In particular, this may depend on whether the top surface of the CSP units 116 is below or above the top surface of the substrate 110. In general, it will be appreciated that the localised electrical connection components or electrical interconnects, such as bump interconnects, between the die 120 and the substrate 110 may be of different size, shape or material from those between the die 120 and the CSP unit 130.

In some embodiments, in particular, in embodiments in which the thickness in a vertical direction, that is to say, the height, of the CSP unit matches the substrate thickness to within manufacturing tolerances, the bottom surface 114 of the substrate is in the same plane as the bottom surface of the CSP unit 130. This is also the case in embodiments in which a difference in height between the CSP unit and the substrate is accommodated by differences in height between the first set of localised electrical connection components 150 and the third set of localised electrical connection components 160.

In other embodiments the bottom surface 114 of the substrate may be above or below the bottom surface of the CSP unit 130. In such embodiments, the second plurality of localised electrical connection components may have a greater or smaller height than a further plurality of electrical components (not shown) which are used to affix the CSP unit 130 the circuit board (not shown), in dependence on whether the bottom surface of the CSP unit 130 is above or below the bottom surface 114 of the substrate.

From the above, it will be apparent that as used herein, the term "positioned in a same plane", when referring to 2 components, is to be interpreted broadly, in the sense that neither component is either entirely below or above the other component. Two components which are "positioned in a same plane" cannot, therefore, be stacked one on top of the other.

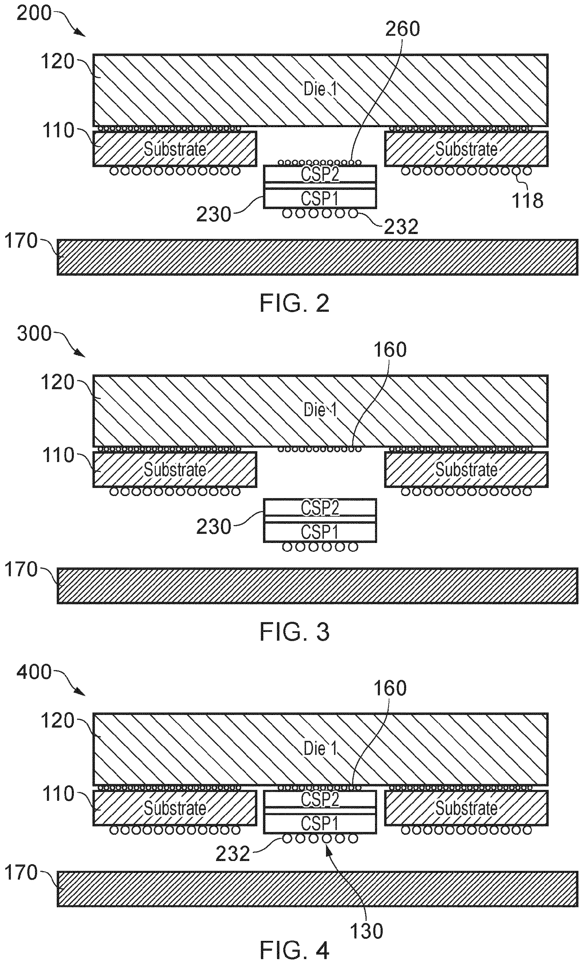

Now to FIGs. 2, 3 and 4, these show various embodiments according to the present disclosure.

Considering FIG. 2, this shows a semiconductor package assembly 200 according to embodiments of the present disclosure, which is adapted for integration with a CSP unit 230. The semiconductor package assembly 200 comprises a first semiconductor die 120 and substrate 110. The substrate is electrically connected to the first semiconductor die 120 by means of the first plurality of localised electrical connection components 150 The semiconductor package assembly 200 does not include a third plurality of localised electrical connection components 160. The semiconductor package assembly 200 is configured for integration with a separate CSP unit 230, onto which are affixed the third plurality of electrical interconnection components 260. Integration with the CSP unit 230 typically may be concurrent with, or may be prior to, mounting the semiconductor package unit 200 onto a circuit board 170, electrical connection is provided between the semiconductor package unit 200 and the circuit board 170 by means of a second plurality of localised electrical Internet components 118.

Considering next FIG. 3, this shows a semiconductor package assembly 300 according to other embodiments of the present disclosure, which is adapted for integration with a CSP unit 230. In this embodiment, the semiconductor package assembly 300 does include the third plurality of localised electrical connection components 160. The separate CSP unit 230, to which the assembly is to be integrated, thus does not have electrical interconnection components on its top surface, since these are already provided in the semiconductor package assembly.

Turning now to FIG. 4, this shows a semiconductor package assembly 400 according to other embodiments of the present enclosure disclosure, which comprises the first semiconductor die 120, the substrate 110 and the CSP unit 130. The CSP unit is affixed to the first semiconductor die through the third plurality of localised electrical connection components 160. This assembly is directly ready for integration onto circuit board 170. The CSP units at 130 thus has a fourth plurality of localised electrical connection components 232 affixed thereto in preparation for mounting on the circuit board.

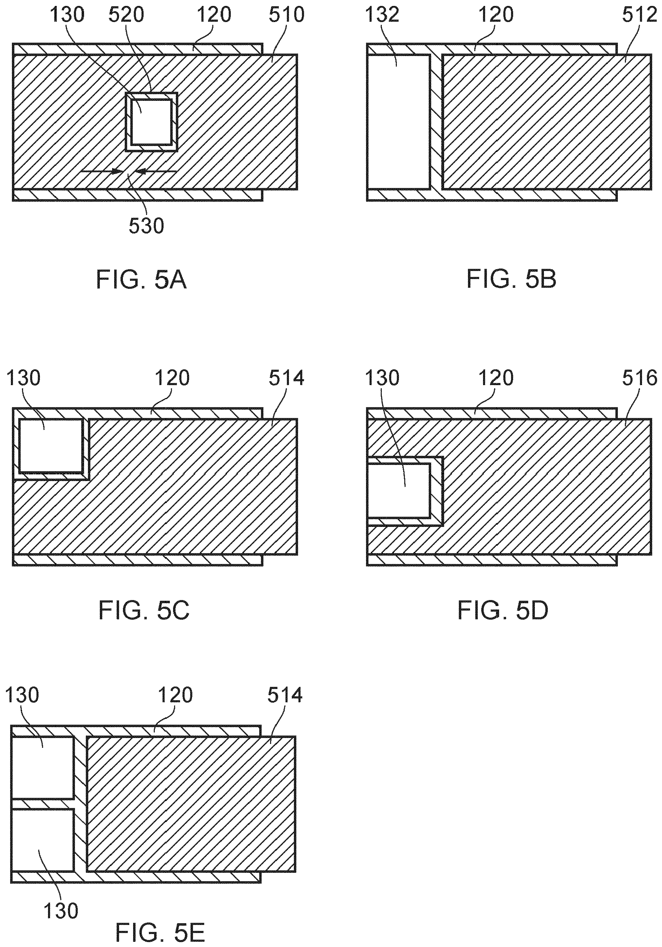

FIGs. 5A - 5E shows, in each case from the underside, various arrangements of the substrate and CSP unit, according to one or more embodiments of the present disclosure. In each of the embodiments shown, the substrate extends, in one direction, beyond the side or edge of the first semiconductor die 120. In other embodiments the semiconductor die extends beyond the side edge of the substrate, and in other embodiments edge of the first semiconductor die 120 is aligned with that of the substrate. For completeness it is mentioned in order to avoid obscuring the figure, the localised electrical connection components on the underside of the substrate and those on the underside of the CSP unit are not shown.

In example FIG. 5A, the substrate 510 includes an aperture or hole 520 through which can be seen a part of the first semiconductor die 120. Located in the aperture is a CSP unit 130. The CSP unit is spaced apart from the substrate by a separation or gap 530. The gap may typically be of the order of 20 µm to 500 µm. A minimum gap may be determined by the capability of a die placement tool or an underfill tool, or manufacturing tolerances. The substrate thus, in this embodiment, completely surrounds the CSP unit.

In example FIG. 5B, the first semiconductor die overhangs a substrate 512 by a sufficient distance to accommodate a CSP unit 132. In this embodiment, the CSP unit 132 is thus adjacent to a substrate 512, and typically larger than the CSP unit 130 in other embodiments. In example FIG. 5C the CSP unit 130 is positioned proximate to 2 sides of a corner cut out of a substrate 514. In example FIG. 5D the CSP unit 130 is positioned proximate to a rectangular notch in one side or edge of a substrate 516. The final depicted embodiment FIG. 5E is similar to that of example FIG. 5B, except that in this case 2 CSP units 134 and 136 are attached to the first semiconductor die along one edge of the die 120. The examples shown in FIG. 5A - FIG. 5E are not intended to be limiting, and the skilled person will readily appreciate that numerous other geometrical arrangements may be used - for instance the multiple CSP units may be positioned in two or more corner cutouts or central apertures in the substrate. Combinations of the above arrangements are also envisaged to be with the scope of the present disclosure.

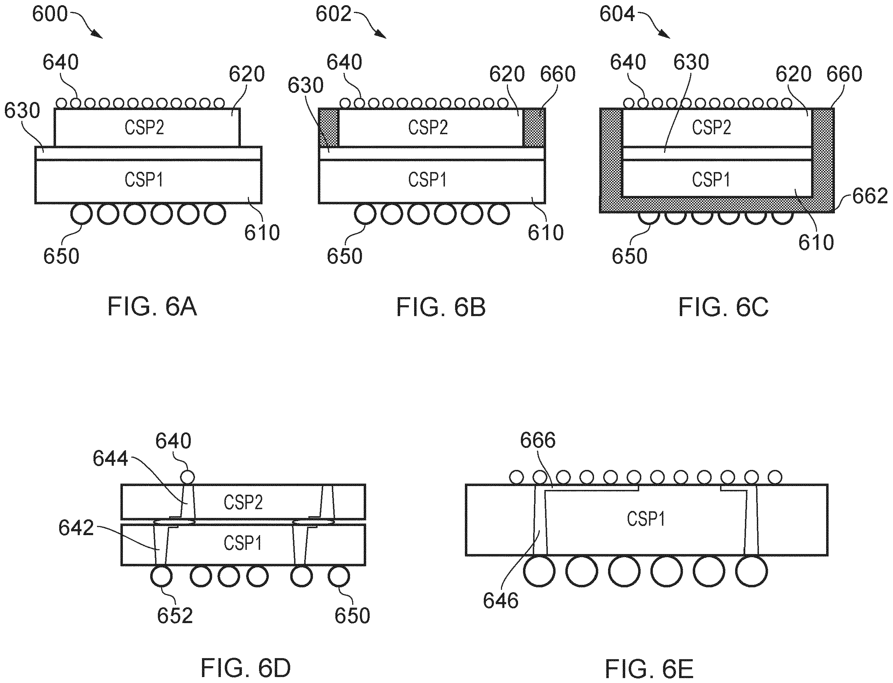

FIG. 6A - FIG. 6E show various configurations of a CSP unit, according to embodiments of the present disclosure. In a first alternative, shown at FIG. 6A, a CSP unit 600 comprises a pair of two semiconductor die 610 and 620, which are mounted back to back. As will be familiar to the skilled person, in order to provide this configuration, a wafer containing a multiple copies of the first die 610 may be mounted onto a grinding tape and thinned by back grinding. Similarly, a second wafer containing multiple copies of the second die 620 may be mounted on further grinding tape, and thinned by back grinding. Die attach film 630 is then affixed to the (exposed) thinned back-side of the second wafer, The die on the second wafer are then flipped, singulated and individually placed onto the first wafer, locating the individual second die 620 on top of the first die 610. Localised electrical connection components 640 are then fabricated on the exposed top surface of the first semiconductor die 620. As will be for the familiar to the skilled person, the localised electrical connection components may be any suitable one of combination of solder balls, plated solder bumps, or (Cu)metal-pillars such as Cu-pillars. The first wafer (with the multiple copies of the second die bonded to it) is then removed from the grinding die and re-mounted, the other way up, in order to expose the original top surface of the first semiconductor die on the first wafer, Localised electrical connection components 650 are then fabricated on the exposed top surface of the first semiconductor wafer having first die 610 thereon. The first wafer is then singulated into individual die 610 It will be appreciated that in this configuration, it may be convenient that the second die is smaller than the first die, in order to ensure that the singulation process for the first die avoids damaging the edges of the already singulated second die mounted thereon.

In a second alternative, shown at FIG. 6B, a CSP unit 602 again comprises a pair of two semiconductor die 610 and 620, which are typically mounted back to back. This CSP unit 602 is similar to that the CSP unit 600 shown in embodiment FIG. 6A, except in that there is included moulding compound 660 protecting the side of the second die 620. The CSP packaging process for this CSP unit 602 is similar to that for CSP unit 600, except that the second wafer is reconstituted, according to known wafer level chip-scale packaging processes. That is to say, the individual die of the second wafer are singulated and placed, more widely separated, into a - generally wafer-shaped - moulding jig (which may also be referred to generically as a "mould"). Moulding compound is then introduced in between the die in order to reconstitute or form a "reconstituted second wafer" with spaced apart by therein. In a next stage of the process, die attach film may be attached to the entire first wafer, and the "reconstituted second wafer" is bonded to the first wafer by the die attach film. The process thereafter is similar to that for CSP unit 600. The singulation of the first wafer into separate die cuts through the moulding compound 660 between the second die 620. In consequence, the sides of the CSP unit 602 are partially protected by moulding compound.

In a third alternative, shown at FIG. 6C, a CSP unit 604 again comprises a pair of two semiconductor die 610 and 620, which are typically mounted back to back. This CSP unit is similar to the CSP unit 602, except that in CSP unit 604, the sides are completely protected by moulding compound, as is the lower surface of the first die. As will be familiar to the skilled person, the packaging assembly process to provide this units is similar to that for unit 602, except that in this embodiment, both first and second wafers are singulated, and reconstituted by placing the die widely apart (that is to say, with a separation between which is greater than the saw-lane and/or greater than the separation of the die on the wafer during fabrication before singulation). As shown, the localised electrical interconnects components 650 may be provided on the first die 610 prior to singulation of the first wafer. Reconstitution may then include providing moulding compound 662 across the top surface between the localised electrical Internet components thus providing five side protection to the CSP unit 604. The skilled person will appreciate that in another alternative (not shown) six-sided protection may be provided for the CSP units by providing moulding compound across the top surface of each of the first and second die during the reconstitution process.

The skilled person will also appreciate that, for each the die which are singulated and reconstituted, its may be possible to flip the individual die during the simulation reconstitution process, which thus provides the possibility of mounting the die front to back, or even front to front. In order to do so, through silicon vias (TSVs) may be required, as shown in alternative (iv) at 642 and 644. It will be noted that the use of TSVs does not preclude back to back for back to front mounting of the die. Through silicon vias may provide direct connection to the remote or distal die, as shown for example by the localised electrical interconnection components 642 and 652 shown in alternative FIG. 6D, in addition to providing connections to the adjacent proximate die as shown at 650 in alternative FIG. 6D.

Finally, at FIG. 6D is shown a CSP unit which consists of a single CSP device. In this particular example, the backside of the wafer may include routing 666 in order to facilitate bump or LGA ("land grid array") type electrical connections. The die may also include TSVs 646. The CSP device may include moulding protection on its sides (not shown) particularly in the case of a reconstituted wafer which may include redistribution layers. Alternatively, the CSP device may have localised electrical connection components fabricated on both sides, during the wafer scale processing - in that instance no moulding compound may be required.

From FIG. 6A - FIG. 6E, the skilled person will appreciate that many alternative arrangements of a CSP unit are envisaged, including but not limited to those described above and combinations thereof, some of which comprise a stack of two CSP devices and some others of which comprise only a single CSP device.

In the embodiment of the present disclosure including or accommodating a single CSP device, the substrate may be thinner than in embodiments including accommodating a CSP unit consisting of pair of stacked CSP devices; in other embodiments the single CSP device may be seen to a lesser extent (sorry but not at all, such that the substrate thickness is the same as would be the case for a pair of the fact CSP devices.

As already mentioned, as used herein, the term "localised electrical connection component" encompasses known techniques such as provision of solder bumps, balls, and copper stacks. It will be appreciated, that embodiments of the present invention generally do not require wirebonding or the like. The electrical components are localised in the sense that they provide vertical connection between bond pads of the respective devices or substrates. Of course, it will also be appreciated that embodiments of the invention can utilise one or more redistribution layers in the substrate or the CSP unit.

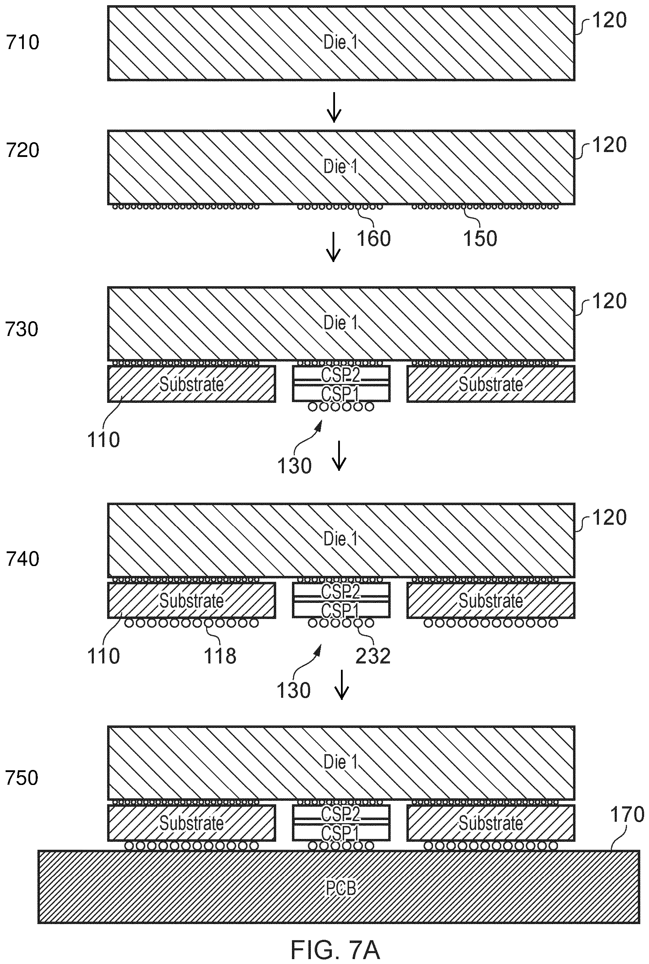

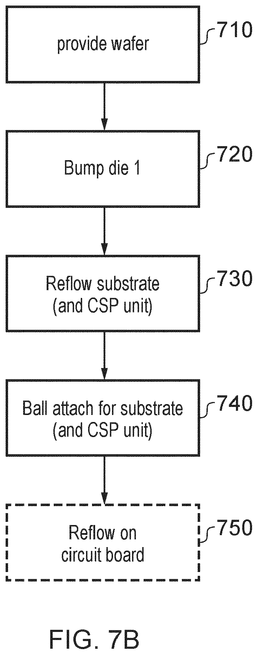

FIG. 7A and FIG. 7B shows an example of a package assembly process according to one or more embodiments. FIG. 7A illustrates a cross-sectional view of each step and FIG. 7B illustrates a flowchart of the process. A first semiconductor die 120 is provided at step 710 ("provide wafer"). Localised electrical connection components are affixed to the die at step 710 ("bump die 1"). This step may generally be referred to as bump die 1; however, as discussed above the localised electrical connection components may be any of bumps, solder balls, or metal pillars (which may typically include a hard metal such as copper for some or all of the pillar and which may include one or more soft metal on either the top or bottom surface to provide better electrical connection. The localised electrical connection components include a first group 150 and may optionally include a second group 160. A third step 730 ("reflow substrate and CSP unit") comprises reflowing the substrate 110 (and optionally a CSP unit 130). A fourth step 740 ("ball attach for substrate and CSP unit") comprises ball attach for substrate (and optionally for the CSP unit in embodiments in which the CSP unit was attached to the first semiconductor die in step 730). In this step the third and fourth localised electrical connection components 118 and 232 are provided.

For use, during a further step 750 ("reflow on circuit board") the semiconductor package assembly, a known reflow process is applied to third and fourth localised electrical connection components 118 and 232 in order to mount the semiconductor package assembly on a circuit board and electrical connection between the circuit board and, respectively, the substrate and the CSP unit.

In one or more embodiments, the reflow process at step 730 may be the so-called "C4" process ("Controlled Collapse Chip Connection"). Furthermore, the reflow process at step 750 may be the so-called "C5" processed ("Controlled Collapse Chip Carrier Connection"). The reflow process is 730 and 750 may use the same temperature. In other embodiments the reference reflow process 750 may use a lower temperature than that of 730, in order not to melt the localised electrical interconnection components 150. The temperature chosen for the reflow depends, as the skilled person will be aware, on the choice of materials for the localised electrical connection components, and in particular whether the components are balls, bumps, or pillars.

From reading the present disclosure, other variations and modifications will be apparent to the skilled person. Such variations and modifications may involve equivalent and other features which are already known in the art of semiconductor packaging and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

## Claims

1. A semiconductor package assembly (200) comprising:
a substrate (110) having a substrate top surface (124) and a substrate bottom surface (114);
a first semiconductor die (120), partially over the substrate and having a die bottom surface (124) having first and second pluralities of I/O pads thereon;
a first plurality of localised electrical connection components (150), between and affixed to each of the die bottom surface and the substrate top surface and providing electrical connections between the substrate and the first plurality of I/O pads; and
a second plurality of localised electrical connection components (118), affixed to the substrate bottom surface, and for providing electrical connection between the substrate and a circuit board (170);
wherein the second plurality of I/O pads are arranged for providing electrical connections to a chip-scale-package unit (230) to be affixed to the first semiconductor die by a third plurality of localised electrical connection components (160, 260), and to be positioned in a same horizonal plane as the substrate.

2. A semiconductor package assembly according to claim 1, further comprising
the third plurality of localised electrical connection components affixed to the die bottom surface and for providing electrical connection between the first semiconductor die and the chip-scale-package unit.

3. A semiconductor package assembly according to claim 2, further comprising
the chip-scale-package unit, having a chip-scale-package unit top surface to which the third plurality of localised electrical connection components are affixed and a chip-scale-package unit bottom surface.

4. A semiconductor package assembly according to claim 3, wherein
the chip-scale-package unit is proximate to the substrate on at least two sides.

5. A semiconductor package assembly according to claim 3 or 4, wherein
the chip-scale-package unit is surrounded by the substrate on all sides.

6. A semiconductor package assembly according to claim 3 to 5, wherein
each side of the chip-scale-package unit is laterally spaced apart from the substrate by at least a distance.

7. A semiconductor package assembly according to any preceding claim, further comprising:
a fourth plurality of localised electrical connection components, affixed to the substrate bottom surface and for providing electrical connection between the substrate and a circuit board.

8. A semiconductor package assembly according to claim 3, or any of claims 4 to 7 when depending on claim 3, further comprising:
a fifth plurality of localised electrical connection components, affixed to the chip-scale-package unit bottom surface and for providing electrical connection between the chip-scale-package unit and a circuit board.

9. A semiconductor package assembly according any preceding claim, wherein
the substate extends laterally beyond the semiconductor die.

10. A semiconductor package assembly according to any of claims 1 to 8, wherein
the semiconductor die extends laterally beyond the substrate.

11. A semiconductor package assembly according to claim 3, or any of claims 4 to 9 when depending on claim 3, wherein
the chip-scale-package unit substate extends laterally beyond the semiconductor die.

12. A semiconductor package assembly according to claim 3, or any of claims 4 to 11 when depending on claim 3, wherein
the chip-scale-package unit consists of a single chip-scale-package die.

13. A semiconductor package assembly according to claim 3, or any of claims 4 to 12 when depending on claim 3, wherein
the chip-scale-package unit comprises a stacked pair of chip-scale-package die.

14. A semiconductor package assembly according to claim 13, further comprising moulding compound at least partially surrounding at least one of the pair of chip-scale-package die.

15. A method of assembling a semiconductor package comprising:
providing a first semiconductor die;
providing a first plurality of localised electrical connection components on the first semiconductor die;
affixing a substrate to the first plurality of localised electrical connection components; and
affixing a chip-scale-package unit in a same plane as the substrate, to the first semiconductor die.
